(19) **Europäisches Patentamt**

**European Patent Office**

**Office européen des brevets**

(11) **EP 0 691 802 B1**

(12) **EUROPEAN PATENT SPECIFICATION**

(45) Date of publication and mention
of the grant of the patent:
**28.08.2002 Bulletin 2002/35**

(51) Int Cl.[7]: **H05K 3/46**, G03F 7/027

(21) Application number: **95304322.1**

(22) Date of filing: **21.06.1995**

(54) **Method and composition for forming a multilayer printed circuit board**

Verfahren und Zusammensetzung zur Herstellung einer mehrschichtigen Leiterplatte

Procédé et composition de fabrication d'un panneau à circuit imprimé multicouche

(84) Designated Contracting States:
**AT BE CH DE ES FR GB IT LI NL SE**

(30) Priority: **07.07.1994 US 271614**

(43) Date of publication of application:
**10.01.1996 Bulletin 1996/02**

(73) Proprietor: **Morton International, Inc.**
**Chicago, Illinois 60606-1596 (US)**

(72) Inventors:
• **Rath, James**
**Orange, California 92669 (US)**
• **Tran, William Luong-Gia**
**Garden Grove, California 92641 (US)**
• **Flynn, Kathy M.**
**Santa Clarita, California 91351 (US)**
• **Tara, Vinai Ming**
**Anaheim, California 92804 (US)**
• **Koes, Thomas A.**
**Riverside, California 92503 (US)**
• **Nizzo, Vincent J.**
**Tustin, California 92680 (US)**

(74) Representative:
**Bankes, Stephen Charles Digby et al**
**BARON & WARREN**
**18 South End**
**Kensington**
**London W8 5BU (GB)**

(56) References cited:
**EP-A- 0 403 170        EP-A- 0 570 094**

• **PATENT ABSTRACTS OF JAPAN vol. 12, no. 491
(C-554) 21 December 1988 & JP-A-63 205 313
(HITACHI) 24 August 1988**
• **PATENT ABSTRACTS OF JAPAN vol. 12, no. 148
(C-493) 7 May 1988 & JP-A-62 265 321 (HITACHI)
18 November 1987**

## EP 0 691 802 B1

**Description**

The present invention is directed to a method for forming a multilayer printed circuit board, and more particularly to a method of forming a multilayer printed circuit board in which a photoimageable composition used to print the individual innerlayers forms substantially all of the dielectric material separating the innerlayers from each other.

Multilayer printed circuit boards comprise a stack of individual printed circuit boards or innerlayers separated by dielectrical material. The circuitry of the several innerlayers is electrically connected by bored and plated- through holes. Multilayer printed circuit boards provide circuitry in a three-dimensional array and are therefor advantageously space-saving, relative to individual printed circuit boards, which provide at most two layers of circuitry on a two-sided board.

These printed circuit boards are commonly provided with internal ground and power planes. These internal planes are frequently solid sheets of copper interrupted only by clearance holes (the perforations required for electrically isolating the through hole pattern of the printed circuit board). Ground and power planes provide power voltage and current and ground connections for the components of the multilayer printed circuit. A second function of the ground and power planes is to provide electromagnetic shielding for the multilayer printed circuit board and reduce the electromagnetic and radio frequency interference. Multiple ground and power planes and additional ground planes on the surface layers with the conductive pattern are common.

When components are mounted on a multilayer printed circuit board and mass soldered in place at temperatures on the order of about 275°C (527°F), a severe thermal shock is applied to the insulating layers placed between two copper planes, such as the insulating layer between an internal ground plate and ground shield on the surface surrounding the conductor pattern. Frequently, delamination will occur and blisters will form between the ground shield on the surface and the internal ground or power plane. Delamination and blistering have been a problem with multilayers made by a fully additive, semi-additive, or subtractive sequential processes.

In a conventional subtractive procedure for forming multilayer printed circuit boards, the innerlayers are formed in the manner of individual two-sided printed circuit boards. A blank board formed of epoxy that is covered on each side with a metal layer, such as copper, is coated on each side with a layer of primary photoresist. The primary photoresist may be coated as a liquid resist or applied as a dry film. The layers of photoresist are exposed to patterned actinic radiation by placing artwork over the photoresist layers and directing light through the artwork to the photoresist layers. Subsequently, the exposed photoresist layers are developed in an appropriate aqueous medium to remove exposed or unexposed portions of the photoresist layers, depending upon whether the photoresist is positive-acting or negative-acting. The metal layer is then etched away in the areas from which the overlying photoresist has been removed. After etching, the remaining portions of the photoresist layers are stripped from the surfaces of the board. In the conventional procedure, the copper surfaces which have been uncovered by the stripping process are then treated to enhance adhesion of the copper to the pre-preg in subsequent steps.

The individual innerlayers are stacked with alternating layers of "prepreg" material, which typically comprises an epoxy/fiberglass composition. The assembly of innerlayers and prepregs is then pressed together and heated. The pre-preg material initially flows under the heat and pressure, filling the voids between the innerlayers, and eventually cures under these conditions to form a hard permanent dielectric material separating the individual circuitry layers.

It has been the practice to apply an initial, strongly adherent oxide layer to the copper to enhance the bond between the copper conductive patterns and the insulating layers. The oxide layers are usually applied by immersing the copper surface in hot (40°-110°C), strongly alkaline, hypochlorite solutions. This immersion produces a black, dendritic oxide layer with a high surface area for adhering to organic films, coatings, and laminated layers. In the printed circuit industry, this oxide is commonly called "black oxide".

To electrically connect the circuitry of the several innerlayers, holes are drilled through the cured assembly. The heat so generated causes an epoxy resin "drill smear" on the inner layer copper surface around the drilled hole prior to the electroless plating of the hole wall. The hole walls are plated to create electrical connections to the inner copper planes. The desmearing and plating solutions dissolve the black oxide surrounding the holes and leave non-adherent rings around the holes. This is known as "pink ring" because of the ring of copper visible in the pattern of black oxide. At the pink ring, the adhesion between the copper plane and the laminated insulating layer over it is reduced. Ionic contamination and the failure of insulation between holes occur where pink ring is found.

EP-A-570094 discloses a process for fabricating a multilayer printed circuit board, which comprises:

(A) providing a plurality of innerlayer boards, each comprising a dielectric base and a metal layer thereon;
(B) coating each of the metal layers with a layer of a photoimageable composition comprising:

(a) from 10 to 40%by weight of a polymerizable acrylate monomer;
(b) from 5% to 35% by weight of an oligomer consisting of a diester of a bisphenol A epoxy resin and acrylic or methacrylic acid;

(c) a photosensitive, free radical generating initiator for polymerization of the acrylic monomer and oligomer;

(d) a curable epoxy resin;

(e) a curing agent for the epoxy resin; and

(f) from 0% to 15% by weight of a cross-linking agent reactive with hydroxyl groups, all based on the total weight of components (a) through (f);

(C) exposing each of said layers of photoimageable composition to a pattern of actinic radiation to polymerize the acrylic monomer and oligomer;

(D) creating photoimaged layers of the composition on the boards by dissolving the unexposed portions of each layer in an aqueous alkaline medium to uncover metal according to the pattern;

(E) etching the uncovered metal to remove it;

(F) stacking the boards having the photoimaged layers and applying heat and pressure to the stack to cure the composition in each layer and form hard, permanent innerlayers between the boards; and

(G) connecting the circuitry of the stacked boards.

According to a first aspect of the present invention there is provided a photoresist composition comprising:

(a) from 5 to 7.1% by weight of trimethylolpropane triacrylate;

(b) from 32.4 to 34.3% by weight of an oligomer comprising a diacrylate ester of a bisphenol A epoxy resin;

(c) a photosensitive, free radical generating initiator for polymerization of the acrylate monomer and the oligomer;

(d) from 35.5 to 37.6% of an epoxy cresol novolac resin;

(e) a curing agent for the epoxy resin;

(f) from 0% to 15% by weight of a cross-linking agent reactive with hydroxyl groups, all based on the total weight of components (a) through (f); and

(g) up to 4% by weight of a filler.

The content of trimethylol propane triacrylate is preferably 6.7 to 7.1 wt. %

According to a further aspect of the invention there is provided a process for fabricating a multilayer printed circuit board comprising:

(A) providing a plurality of innerlayer boards, each comprising a dielectric base and having at least one metal layer thereon;

(B) coating each of said metal layers with a layer of a photoimageable composition as defined above which composition is curable to form a hard, permanent dielectric material,

(C) exposing each of said layers of photoimageable material with patterned actinic radiation;

(D) developing said exposed layers to remove either exposed or non-exposed portions, leaving non-exposed or exposed portions of said photoimageable composition layers on said metal layers;

(E) etching said metal layers of said innerlayer boards to remove portions of said metal layers from which said photoimageable composition layer portions were removed; and

(F) without removing remaining portions of said photoimageable composition from said etched metal layers; stacking said innerlayer boards and subjecting said boards to heat and pressure so that said photoimageable composition initially fills voids between the innerlayer boards at least partially and then cures to form hard, permanent, dielectric layers separating circuitry of adjacent innerlayers.

According to a further aspect of the invention, there is provided a multilayer printed circuit board as defined by claim 16.

In accordance with the process of the present invention, the boards to be used as innerlayers of a multilayer printed circuit board are formed using a resist that is not only photoimageable but is hardenable to form a permanent dielectric material. The individual innerlayers can be printed in a usual manner. A board of dielectric base material, such as a glass fiber reinforced epoxy resin, having a layer of copper on each side thereof is covered on both sides with a hardenable photoimageable resist. The resist may be applied by a variety of methods such as screen printing, electrostatic spray coating, spin coating, curtain coating, single- or double-sided roler coating, dip coating, extrusion coating, or as a layer or laminate of dry film. The resist is then exposed to patterned actinic radiation and developed in an appropriate developer to remove either the exposed or non-exposed portions of the photoresist. Next, the processed board is subjected to an alkaline etch or an etch with an acidic solution of cupric/cuprous chloride that removes the metal layers from those regions where the resist has been removed. The resist, rather than being stripped after exposure, development and etching, is left on the innerlayers as a supplement for or replacement of the prepregs normally used to form dielectric layers between the innerlayers. In the manner of prepregs, the photoimageable composition layer, under heat and pressure, initially conforms to the contours of the innerlayers, filling in the voids between the innerlayers, and subsequently cures to form at least a portion of permanent dielectric layers separating the circuitry of the individual innerlayers. The multilayer board is completed in a normal manner by boring holes through the cured assembly, removing the "drill smear" from the copper layers, and lining the bored holes with metal by an electroless plating procedure.

Preferred embodiments of the invention will now be described with reference to the accompanying drawings wherein:

Figure 1 is an elevation of an assembly of exposed, developed and etched innerlayers of this invention between two outerlayers as they are about to be pressed to form a multilayer printed circuit board in accordance with the present invention.

Figure 2 is an elevation of a multilayer board made from the assembly of Figure 1.

The particular monomer combinations, monomer/oligomer combinations, and their interaction with other components in the formulation will affect the degree of tackiness and other properties that are desired. Preferably, the photoimageable composition is prepared in two parts, the first part containing the oligomer and the second containing the epoxy resin, and then mixed shortly before application to the substrate. The temperature during preparation is chosen to facilitate high shear mixing of the components of the two parts; it may be conveniently at room temperature or high as about 93°C (200°F) at super-atmospheric pressure.

As described above, the photoimageable composition is applied as a layer to the copper clad substrate (or to a support sheet to form a dry film which is then laid on the copper). The particular application method used will depend to some degree on the particular formulation of the photoimageable composition used. In a preferred roller coating operation, there is no differential between the speed of the photoresist application rollers and the drying oven speed so that scoring at the edges of the board does not occur. The conveyor speed may from 1.52 to 2.13m (5 to 7 feet) per minute. Suitably, the groove density of the rollers is 16 threads per cm (40 threads per inch), the groove depth is 0.254 mm (0.010 inch), and the groove angle is 76°. After application, the wet layer is dried to remove organic solvent. During this drying, some reaction of components may occur. The thermally driven reaction serves to increase crosslink density and advance the overall molecular weight of the film. Condensation reactions may occur between an anhydride and a melamine-formaldehyde resin, or between an epoxy cresol novolac and a hydroxyl- and/or carboxylic acid functional oligomer.

If there is a significant hold time after drying before the desired exposure of the photoimageable layer, it may be covered by a sheet of black polyethylene or the like. It is then exposed to patterned actinic radiation at an energy level sufficient to cause enough crosslinking to prevent attack by the aqueous alkaline developer that follows in the conventional process. The intensity and time of the light exposure must also be correlated with the drying temperatures and the oven conveyor speed to achieve the optimal performance. It is preferred to effect a UV cure at an energy level of from about 150 to 350 millijoules/cm$^2$ to tie up any unreacted acrylate prior to lamination and preferably after etching of the copper exposed by the developer. Additional UV flood irradiation upon development prior to etching of the exposed copper is not required.

The ability to be developed with aqueous or alkaline aqueous solutions and with or without organically based antifoam agents, is an important advantage of the photoimageable composition of the present invention. Eliminating the need for solvent-based developers eliminates the cost of the solvents as well as health, environmental and recycling problems. Although the films formed in accordance with the invention are developable in aqueous solutions without any organic solvents, developers may include some organic solvents, providing that the added organic solvent does not solubilize the exposed portions of the film.

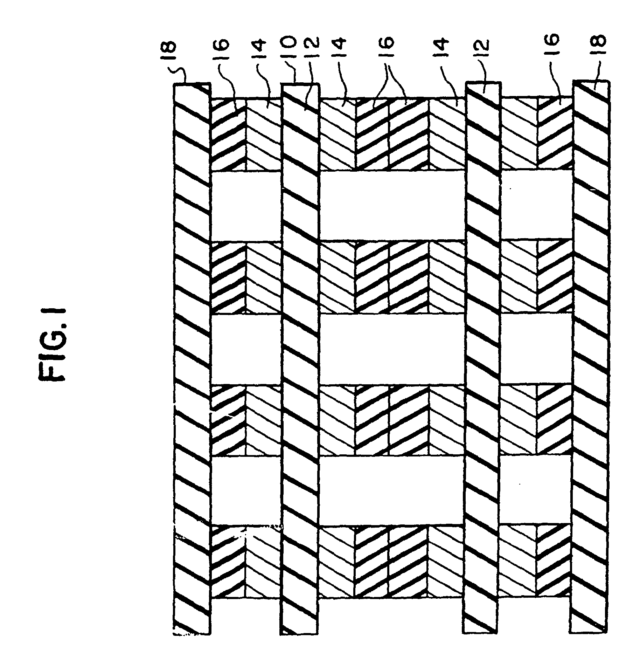

In Figure 1 of the drawings, each innerlayer 10 comprises a base layer 12 of dielectric material, circuitry traces 14 on the opposite faces thereof, and the photoimageable composition 16 overlying the circuitry traces 14. Although not shown here for the sake of clarity, the outerlayers 18 may have circuitry traces on their inner faces, only, before pressing of the assembly; the outer faces thereof would still retain a bare layer of copper foil which may be coated with resist, exposed, developed, and etched after the multilayered board comes out of the press.

In the prior art method of forming a multilayer circuit board, the photoimageable composition used instead of composition 16 would have been stripped from the circuitry traces 14 and the exposed circuitry traces would have been treated in a chemical bath. In the process of the present invention, the photoimageable composition 16 is not stripped. The need for a stripper is eliminated, as are any problems associated with disposal of the stripper. Elimination of the stripping stages of the conventional process permits increased throughput of a multilayer board and reduces the resources required for its production.

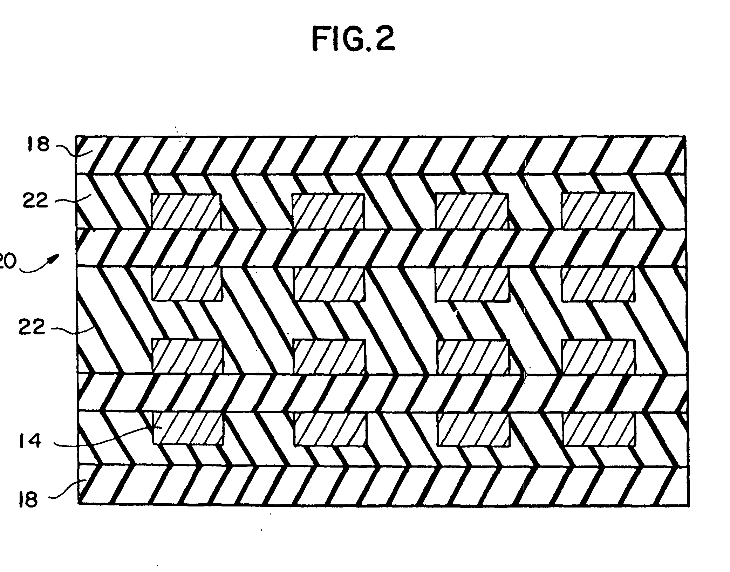

At this point, there are several options available in forming the multilayer circuit board. In the option shown in Figures 1 and 2, the innerlayers 10 and outerlayers 18 are merely stacked in a standard multilayer press and the assembly is subjected to heat and pressure which initially squeezes the still flowable photoimageable composition 16 into the voids between the innerlayers 10 to form the board 20 of Figure 2. The board 20 is maintained under heat and pressure for from about 3 to about 3.6 hours, during which time the photoimageable composition 16 cures to form hardened, permanent dielectric layers 22 which electrically separate the circuitry traces 14 of the innerlayers 10.

The conditions of heat and pressure are somewhat dependent upon the particular photoimageable composition selected for the process. In a suitable procedure known as the hot start/dual pressure procedure or the "kiss" procedure, the assembly is held at about 350°F (177°C) at about 345 kPa (50 psi) for a short while and then the pressure is increased to from 3.1 to 4.83 MPa (450 to 700 psi). In the hot start/full pressure procedure, the temperature is 177°C (350°F) but a pressure of from 4.14 to 5.52 MPa (600 to 800 psi) (56 kg/cm$^2$) is held for the full 3 to 3.6 hours. The cured assembly is suitably cooled down at a rate of about 6°C (10°F)/min. An optional postbake of the dielectric layers 22 may be used to further cure or anneal it.

The option of utilizing only the photoimageable composition to form the dielectric layer 22 has the advantage of eliminating any need for prepregs or additional material, the inclusion of which would constitute additional effort. On the other hand, if only the photoimageable composition 16 is to be used to form the dielectric layers 22, it must be applied relatively thickly in order that the portions of the photoimageable composition 16 remaining after development provide sufficient material to not only fill in the voids between the traces 14 but also to provide a sufficiently thick dielectric barrier between the traces of adjacent innerlayers 10. Because the photoimageable composition is relatively expensive, thick layers of it are expensive to produce. Also, a thick photoimageable layer produces poorer resolution than a thin one. If the initially applied photoimageable layers are to serve as the sole source of material for the dielectric layer 22, the thickness of the photoimageable layer will vary from about 55.9 μm (2.2 mils) when 28 g (1 oz.) copper foil (35.6 μm, 1.4 mils thick) is used to about 81.3 μm (3.2 mils) when 57 g (2 oz). copper foil (71 μm, 2.8 mils thick) is used.

Another option (not illustrated) is to apply additional dielectric prepreg material to the board after etching. Again, the photoimageable composition layer is not removed from the traces, avoiding the need for stripper and treatment to avoid oxidation. The additional material could be more of the photoimageable composition 16, a compatible curable system (without the photosensitive components to minimize cost), or even conventional prepregs. In any case, the photoimageable composition layer that is left on the traces forms a portion of the dielectric layers 22 in the multilayer board.

The board 20 is then taken out of the press, the outerlayers are processed as desired and the resulting multilayer board is then processed in a conventional manner. Holes are bored through the layers, and the hole walls are plated to electrically connect the circuitry of the several layers.

The composition 16 according to the present invention includes an acrylic chemical system by which the composition is photo-polymerized and an epoxy chemical system which is curable to harden the composition after exposure and development. The two chemical systems, however, are not exclusive of each other and components of the two chemical systems are believed to interact chemically with each other. This is especially true when the composition includes a cross-linking agent (f).

The acrylic system includes the acrylate monomers (a), the epoxy-acrylate oligomer (c) and the photoinitiator (b). The epoxy system includes the epoxy resin (d) and the acidic curative (e) therefor. If a cross-linking agent (f) is used, it is selected to be reactive with free hydroxyl groups of components of both the acrylic and epoxy systems.

In one preferred embodiment of the invention, the photoimageable composition comprises from 0.1 to 10% of an acidic curative for the epoxy resin; from 1 to 15 % of the cross-linking agent; and up to 4 % by weight of a filler. The preferred composition has a photo-sensitive chemical system which renders exposed portions of the resist insoluble in alkaline aqueous developer and an epoxy-based chemical system which is curable to provide permanence and hardness to the material subsequent to exposure, development, etching and curing.

A level of the acrylate monomer (a) lower than 5 % may be insufficient to insolubilize the portions of the photoresist layer that have been exposed to actinic radiation. Unless otherwise stated, all percentages of components (a)-(f) are calculated relative to the total weight of components (a)-(f). The amounts of any additional ingredients, such as fillers, solvents, etc. are also calculated relative to the sum of the weights of (a)-(f). The dried composition of (a)-(f) is soluble in alkaline aqueous solution, whereby the photoimageable composition layer 16 on a circuit laminate is developable with alkaline aqueous solution.

Epoxy-acrylate (b) typically means herein an oligomer formed from an epoxy backbone which is reacted with acrylic or methacrylic acid, a low molecular weight polyacrylic or polymethacrylic acid, or a mixture of them, so that at least 90% of the epoxy groups are esterified with the acid. In the reaction of the acid with the epoxy groups of the epoxy resin, the acid molecules each form an ester bond with the resin and a hydroxyl group is formed on the vicinal carbon atom. Because substantially all of the epoxy groups are reacted with the acrylic or methacrylic acid moiety, the oligomer functions primarily as an acrylate or methacrylate, said moieties of the oligomer polymerizing along with the acrylic monomers during the photoinitiated reaction which renders exposed portions of the photoimageable composition layer insoluble to aqueous alkaline solution. The substantial hydroxyl functionality provides the basis for cross-linking with the cross-linking agent (f), if such a cross-linking agent (f) is used.

Preferred epoxy-acrylate oligomers are diacrylate (or methacrylate) esters of bisphenol A type resins, novolac resins, and mixtures thereof having a maximum epoxide content of about 0.5 % by weight. These oligomers are developed to combine good UV/EB cure response along with the chemical resistance and durability of the epoxy resins. Said oligomers are derived from bisphenol A resins having a functionality of two so they also have a functionality of two.

The synthesis of polyfunctional acrylate resins and other unsaturated esters from the corresponding epoxy derivatives is described in the following U.S. patents: 3,256,226; 3,317,465; 3,345,401; 3,373,221; 3,377,406; 3,432,478; 3,548,030; 3,564,074; 3,634,542 and 3,637,618. Epoxy-acrylate oligomers used in the photoimageable composition preferably have molecular weights of from 500 to 2000.

Also required in conjunction with the polymerizable acrylate substance is a chemical initiator system which generates free radicals in the presence of actinic radiation and thereby causes the polymerization of the acrylic substances. Polymerization of acrylic monomers and acrylic moieties of the epoxy-acrylate oligomers into a three dimensional structure insolubilizes the photoimageable composition. The choice of the photosensitive, free radical generating initiator system is not considered to be critical to the practice of the present invention, and a wide variety of such compounds may be successfully utilized in the practice of this invention. Examples of chemical photoinitiator systems include benzophenone, benzoin ether, benzil ketals, ispropylthioxanthone and acetophenone and its derivatives. Other suitable initiator systems are described, for example, in U.S. Patent Nos. 3,469,982, 4,451,523 and 4,358,477. The amount of photoinitiator employed may vary over a wide range, depending upon the polymerizable acrylic substances, the particular photoinitiator system and the desired time of development. Generally, the photoinitiator chemical system comprises from 3 to 15 % of the total weight of components (a)-(f).

The material which imparts the excellent hardness and durability to the film or layer after development and final curing is the epoxy cresol novolak resin. At high temperatures and/or in the presence of a catalyst, the epoxy groups of the resin molecules open and react with other materials present. Primarily, the epoxy resin molecules react with the acidic curative (e); however, to a certain extent, the epoxy molecules react during final curing with the cross-linking agent (f), and perhaps also with the photo-polymerized acrylic material and any remaining unpolymerized acrylate monomers or moieties. Preferably, the epoxy resin is solid at about room temperature. The photoimageable composition can be applied as a liquid film to the substrate after dissolving the solid epoxy resin in the solvent-based mixture first.

Epoxy resins used in accordance with the invention preferably have epoxide equivalents of from 90 to 700 .

The photoimageable composition according to this invention is intended to be hardened to form a permanent innerlayer. Hardening is primarily attributed to the curing of the epoxy resin. To promote sufficiently rapid curing of the epoxy resin, the photoimageable composition of the present invention employs an acidic curative. Acidic cure catalysts include not only substances which have free carboxyl groups, but also chemicals such as anhydrides, which may produce free carboxyl groups. For many applications of the invention, an anhydride, e.g., an anhydride of a multifunctional carboxylic acid is the preferred curative. Other useful catalysts are those having a blocked carboxylic group, which becomes deblocked at a threshold temperature. Epoxy cure catalysts are generally used at levels of from about 0.1 to about 10 % of the total weight of components (a)-(f).

Although photoimageable compositions in accordance with the present invention do not necessarily require an additional cross-linking agent, a cross-linking agent (f) is highly desirable. A cross-linking agent is particularly useful in connecting the acrylate chemical system and the epoxy chemical system in a single interconnected network in the innerlayer. Free hydroxyl groups on the epoxy resins and the epoxy- acrylate oligomers, generally provide the basis for such cross-linking. The cross-linking agent (f) is typically used at a level of at least 1 %, preferably 1.5 -5 %.

In accordance with one embodiment of the invention, the cross-linking agent is a melamine-formaldehyde resin. During initial application of the photoimageable composition as a layer, it is believed that the melamine-formaldehyde resin reacts to some extent with the anhydride. This opens the anhydride, providing carboxyl functionality for subsequent epoxy curing. This initial reaction also has a surface drying effect. Melamine/formaldehyde resin acts to cross-link through free hydroxyl groups. The methylol groups of melamine/formaldehyde resins may be alkoxylated to give a suitable cross-linking agent. In accordance with another aspect of the invention, a blocked, multifunctional isocyanate may be used as the cross-linking agent. The blocked isocyanate is selected to deblock generally at the cure temperature of the epoxy resin. An example of a suitable blocked isocyanate is E-caprolactam-blocked isophorone. If a blocked isocyanate is the cross-linking agent and an anhydride is the curative, some preheating of the photoimageable composition at a time prior to cure is desirable. Such preheating opens anhydride species, providing the acid functionality needed to promote curing of the epoxy resin and needed also for alkaline development.

The cross-linking agent may also be cyanoguanidine (also known as dicyandiamide or dicyanamide) or a substituted amino triazine such as 2-[β-(2'-methylimidazolyl-1']-ethyl-4,5-diamino-s-triazine, which is sold under the trademark CUREZOL 2-Mz-Azine. A mixture of the dicyandiamide and substituted triazine may also be used.

The components of the photoimageable composition are selected to be soluble in a common solvent to form a single-phase liquid composition. As mentioned above, the liquid photoimageable composition may be applied to a substrate by a variety of application methods. Each application method has its own peculiarities, and photoimageable compositions in accordance with this invention may be formulated in accordance with the particular requirements of the particular method of application.

Components (a)-(f) are selected such that a dried composition of these is soluble in alkaline aqueous solution, whereby a layer of the photoimageable composition may be developed in alkaline aqueous solution, e.g., 1% sodium carbonate.

A mixture of components (a)-(f) is typically too viscous to be easily applied as a layer; accordingly, it is generally the practice to dilute the components (a)-(f) with an organic solvent. Typically, solvent is used at a level of 10-60 %, but this will vary depending upon the means of application. For screen printing, solvent is generally used at 10-20%; for electrostatic spray coating, at 20-60%; for curtain coating generally at 40-50%; and for application as a dry film typically about 50%. Suitable solvents include, but are not limited to ethylene glycol monoethyl ether, ethylene glycol monopropyl ether, ethylene glycol monobutyl ether, ethylene glycol-2-ethylhexyl ether, ethylene glycol monohexyl ether, diethylene glycol monomethyl ether, diethylene glycol monoethyl ether, diethylene glycol monopropyl ether, diethylene glycol monobutyl ether, dipropylene glycol methyl ether, propylene glycol monobutyl ether, propylene glycol monopropyl ether, propylene glycol methyl ether, ethylene glycol monoethyl ether acetate, ethylene glycol monobutyl ether acetate, diethylene glycol monoethyl ether acetate, diethylene glycol monobutyl ether acetate, propylene glycol monomethyl ether acetate, ethylene glycol diacetate, 2-ethylhexyl acetate, n-butyl acetate, isobutyl acetate, n-propyl acetate, ethyl acetate, diacetone alcohol, dimethyl formamide, isophorone, diisobutyl ketone, cyclohexanone, isobutyl isobutyrate, methyl n-amyl ketone, amyl acetate, methyl amyl acetone, methyl isoamyl ketone, 2-nitropropane, methyl isobutyl ketone, methyl n-propyl ketone, isopropyl acetate, methyl ethyl ketone, tetrahydrofuran, acetone, methyl acetate, N-methyl pyrolidone and butyrolactone.

In addition to the components described above which are essential to a photoimageable composition of this embodiment the invention, the photoimageable composition may optionally contain additional components which are standard in the art. The photoimageable composition optionally may contain organic or inorganic fillers at levels up to 4 %. Some examples of fillers are micro talc, ground polyethylene, clay, fumed silica and polyvinylidene fluoride. Also, relatively small amounts of flow-control agents, dyes, antioxidants, etc. may be added. Fillers may effect the final appearance of innerlayers, e.g. provide a matte finish.

The photoimageable compositions will now be described in greater detail by way of the following example.

EXAMPLE

A composition of this invention was prepared in two parts, the components of which are as follows:

| PART A | |
|---|---|
| Component | % Wt. |
| Novacure 3701 (diacrylate ester of a bisphenol A epoxy resin) | 48.01 |
| 5-(2,5-dioxotetrahydrofuryl)-3-methyl-3-cyclohexene-1,2-dicarboxylic anhydride | 9.45 |
| QITX isopropylthioxanthone | 2.59 |
| Irgacure 907 | 7.35 |
| Cyanoguanidine (CG 1400) | 2.69 |
| BYK 306 | 1.34 |
| BYK 361 | 0.60 |
| Malachite green | 0.30 |
| Ethyl-3-ethoxy propionate | 27.65 |
| | 100.00 |

| PART B | |
| --- | --- |
| Epoxy cresol novolac resin, ECN-1299 | 52.56 |
| Trimethylolpropane triacrylate | 10.03 |
| 2-MZ-Azine (CUREZOL) | 0.40 |
| BYK-306 | 1.54 |
| Cab-O-Sil M5A silica | 6.96 |
| Modaflow | 0.20 |
| Ethyl-3-ethoxy propionate | 28.32 |
| | 100.00 |

For the preparation of Part A, the first two components were mixed with Malachite green in a portion of the proprionate solvent for four hours and controlling the temperature by regulating the speed of the mixer and the flow of cooling water to the reactor jacket. The remainder of the solvent and the remaining components were added while the mixture was stirred at high shear. After a two hour mixing period, the product was filtered through a 10μ bag filter and the filtrate was a dark green viscous paste having a solids content of 76.4 % (w/w), a Hegman grind of >7.5, and a Brookfield viscosity of 14,000 mPas (14000 cps) using a No.7 spindle at 10rpm for 2 minutes at 25° C.

For the preparation of Part B, a portion of the solvent and the epoxy novolac resin were mixed at high shear for two hours. The flow agents, the triacruylate, and the Curezol were added and high shear mixing for 90 minutes followed while controlling the temperature in the same manner. The silica was then added over a one hour period, the remainder of the solvent was added, and the mixture was stirred for another four hours. This part was an opaque tan colored liquid having thixotropic properties. The viscosity was 3600 mPas (3600 cps), the solids content was 69.81 % (w/w), and the Hegman grind was >4.5. Equal parts by weight of Part A and Part B were mixed to obtain a photoresist of this invention containing about 5 % of the acrylate monomer, about 24 % of the epoxy/acrylate oligomer, about 26 % of the epoxy novolac resin, and about 28% solvent, by weight. On a solids basis, therefore, the amount of acrylate monomer is about 6.9 %, the oligomer is about 33.3 %, and the epoxy novolac resin is about 36.1 % of the total weight. Laminates were coated with the photoresist using a Burkle double sided roller coater having a zero speed differential between the application rollers and the oven conveyor belt, which was traveling at about 2.13 m (7 feet)/minute. The wet films were dried in two consecutive temperature zones, the first zone being at 105°C and the second at 177°C. The dry films manifested little or no tack. The average thickness of the four films was $15 \pm 2.5$ μm $(0.6 \pm 0.1$ mil). Diazo artwork was placed directly on the surface of the films and each was exposed to actinic radiation having a predominant wavelength of 365 nm and an exposure energy level averaging $200 \pm 25$ mJ/cm$^2$. The step density in each case was 5 or greater. There was no transfer of the coating from the laminates to the artwork. The 50 % breakpoint averaged $30 \pm 10$ seconds so the developing time in a $1 \pm 0.05$ % aqueous solution of sodium carbonate mono-hydrate at 29°C (85°F) was about $60 \pm 20$ seconds.

After drying, the exposed metal is dissolved by drawing the boards through a 3 Normal aqueous solution of cupric chloride, hydrochloric acid, and chlorine at 49°C (120°F) at a rate of about 76 cm (30 inches) per minute and they are then rinsed and dried. The etched circuit-bearing laminates are then stacked and pressed into a multi-layer board by the "kiss" procedure. Holes are then bored through the multiple layers so that the circuitries of each layer may be connected later by plating the hole walls. The "drill smear" on the inner copper layers must first be cleaned off, however, in a desmearing step by immersing the board in a mixture of butyl cellosolve and monoethanolamine at 54°C (130°F) for 5 minutes, rinsing it with water and then immersing it for five minutes in a mixture of two solutions at 71°C (160°F), one solution being 1 molar in sodium hydroxide and the other 1 molar in sodium permanganate. The board is rinsed with water again before being neutralized by immersion in a mixture of citric acid and sulfuric acid solutions and then dried.

The holes are then plated through first by an electroless plating procedure wherein it is immersed in an aqueous solution of sodium persulfate for a short time at room temperature, then rinsed and treated with an aqueous solution of sodium chloride and hydrochloric acid before being immersed in a catalyst bath of palladium chloride in water at 38°C (100°F) for 3-5 minutes. The board is rinsed again and treated with an aqueous solution of stannous fluoborate to fix the palladium catalyst to the non-conductive surfaces of the board. Again, the board is rinsed and then immersed in an aqueous solution of copper sulfate, a metal chelator such as sodium tartrate, and EDTA at 38°C (100°F) for 20 minutes. The board is then rinsed and treated with a solution of acetic acid and benzotriazole to inhibit oxidation and dried. In the second plating step the copper plated walls of the holes are given a thicker layer of copper in an electroplating process wherein the thin copper lining of the holes acts as the cathode as the copper ions in a bath of dilute sulfuric acid and copper sulfate are reduced and are replenished by a copper anode.

## EP 0 691 802 B1

**Claims**

1. A process for fabricating a multilayer printed circuit board (20) comprising:

   (A) providing a plurality of innerlayer boards (10), each comprising a dielectric base (12) and having at least one metal layer (14) thereon;
   (B) coating each of said metal layers with a layer of photoimageable composition (16), which photoimageable composition is curable to form a hard, permanent, dielectric material, and which comprises (a) a polymerizable acrylate monomer, (b) an oligomer consisting of a diester of a bisphenol A epoxy resin and acrylic or methacrylic acid, (c) a photosensitive, free radical generating initiator for polymerization of the acrylic monomer and oligomer, (d) a curable epoxy resin, (e) a curing agent for the epoxy resin and optionally (f) from 0% to 15% by weight of a cross-linking agent reactive with hydroxyl groups, all based on the total weight of components (a) through (f);
   (C) exposing each of said layers of photoimageable material with patterned actinic radiation;
   (D) developing said exposed layers to remove either exposed or non-exposed portions, leaving non-exposed or exposed portions of said photoimageable composition layers (16) on said metal layers (14);
   (E) etching said metal layers of said innerlayer boards to remove portions of said metal layers from which said photoimageable composition layer portions were removed; and
   (F) without removing remaining portions of said photoimageable composition from said etched metal layers, stacking said innerlayer boards and subjecting said boards to heat and pressure so that said photoimageable composition initially fills voids between the innerlayer boards at least partially and then cures to form hard, permanent, dielectric layers (22) separating circuitry of adjacent innerlayers,

   **characterised in that** the photoimageable composition comprises:

   (a) from 5 to 7.1% by weight of trimethylolpropane triacrylate;
   (b) from 32.4 to 34.3% by weight of an oligomer comprising a diacrylate ester of a bisphenol A epoxy resin;
   (c) a photosensitive, free radical generating initiator for polymerization of the acrylate monomer and the oligomer;
   (d) from 35.5 to 37.6% of an epoxy cresol novolac resin;
   (e) a curing agent for the epoxy resin;
   (f) from 0% to 15% by weight of a cross-linking agent reactive with hydroxyl groups, all based on the total weight of components (a) to (f); and
   (g) up to 4% by weight of a filler.

2. A process according to claim 1 wherein the trimethylol propane triacrylate is present in an amount of at least 6.7 wt.% based on the total of components (a) to (f).

3. A process according to claim 1 or claim 2 wherein the epoxy resin (d) has an epoxide equivalent of from 200 to 700.

4. A process according to any preceding claim wherein the amount of the photosensitive, free-radical generating initiator (b) is from 3 to 15% of the total weight of components (a) - (f).

5. A process according to any preceding claim wherein the photoimageable composition comprises from 0.1 to 10% of an acidic curative (e) for the epoxy resin and from 2 to 15% of the cross-linking agent (f).

6. A process according to claim 5 wherein the photoimageable composition comprises from 2 to 5% of the hydroxyl group-reactive cross-linking agent.

7. A process according to any preceding claim wherein said components (a)-(f) are selected so that the composition is soluble in an organic solvent to give a solution capable of drying to a composition which is soluble in alkaline aqueous solution, whereby said photoimageable composition is developable in aqueous or alkaline aqueous solution.

8. A process according to any preceding claim wherein the cross-linking agent is a mixture of cyanoguanidine and substituted amino triazine.

9. A process according to claim 8 wherein the substituted triazine is 2-[β-{2'-methylimidazolyl-1'}]-ethyl-4,5-diamino-

9

s-triazine.

10. A process according to any preceding claim wherein the initiator is from 3 to 15% and the cross-linking agent is from 1 to 5% by weight of the photoimageable composition.

11. A photoresist composition comprising:

(a) from 5 to 7.1% by weight of trimethylolpropane triacrylate;
(b) from 32.4 to 34.3% by weight of an oligomer comprising a diacrylate ester of a bisphenol A epoxy resin;
(c) a photosensitive, free radical generating initiator for polymerization of the acrylate monomer and the oligomer;
(d) from 35.5 to 37.6% of an epoxy cresol novolac resin;
(e) a curing agent for the epoxy resin;
(f) from 0% to 15% by weight of a cross-linking agent reactive with hydroxyl groups, all based on the total weight of components (a) through (f); and
(g) up to 4% by weight of a filler.

12. A composition according to claim 11 wherein the cross-linking agent is a mixture of cyanoguanidine and substituted amino triazine.

13. A composition according to claim 12 wherein the substituted triazine is 2-[β-{2'-methylimidazolyl-1'}]-ethyl-4,5-diamino-s-triazine.

14. A composition according to any one of claims 11 to 13 wherein the initiator is from 3 to 15% and the cross-linking agent is from 1 to 5% by weight of the photoresist.

15. A composition according to any one of claims 11 to 14 which contains 6.7 to 7.1 wt. % of trimethylol propane triacrylate.

16. A multilayer printed circuit board (20) fabricated with a permanent innerlayer photoresist (22), said photoresist comprising a light- and heat-cured reaction product of components (a) to (f) of a photoresist composition according to any one of claims 11 to 15 and optionally up to 4% by weight of a filler.

17. A board according to claim 16 wherein the epoxy resin (d) has an epoxide equivalent of from 200 to 700.

18. A board according to claim 16 or claim 17 wherein the amount of the photosensitive, free-radical generating initiator is from 3 to 15% of the total weight of components (a)-(f).

**Patentansprüche**

1. Verfahren zur Herstellung einer mehrschichtigen bedruckten Schaltungsplatine (20), indem man

A) mehrere Platinen (10) als innerste Schicht jeweils mit einer dielektrischen Basis (12) und wenigstens einer Metallschicht (14) darauf vorsieht,

B) jede der Metallschichten mit einer Schicht einer Lichtabbildungszusammensetzung (16) beschichtet, wobei diese Lichtabbildungszusammensetzung unter Bildung eines harten, dauerhaften dielektrischen Materials härtbar ist und (a) ein polymerisierbares Acrylatmonomer, (b) ein aus einem Diester eines Bisphenol-A-Epoxyharzes und Acryl- oder Methacrylsäure bestehendes Oligomer, (c) einen lichtempfindlichen, freie Radikale erzeugenden Initiator zum Polymerisieren des Acrylmonomers und Oligomers, (d) ein härtbares Epoxyharz, (e) ein Härtungsmittel für das Epoxyharz und gegebenenfalls (f) 0 bis 15 Gew.-% eines Vernetzungsmittels, das mit Hydroxylgruppen reagiert, wobei alle diese Komponenten auf dem Gesamtgewicht der Komponenten (a) bis (f) beruhen, um faßt,

C) jede dieser Schichten von Lichtabbildungsmaterial mit aktinischer Strahlung in Musterform belichtet,

D) die belichteten Schichten entwickelt, um entweder belichtete oder nicht belichtete Bereiche zu entfernen, so daß nicht belichtete oder belichtete Bereiche der Lichtabbildungszusammensetzungsschichten (16) auf den Metallschichten (14) verbleiben,

E) die Metallschichten der Platinen als innerste Schicht ätzt, um Bereiche dieser Metallschichten zu entfernen, von denen die Lichtabbildungszusammensetzungsschichtbereiche entfernt wurden, und

F) ohne Entfernung restlicher Bereiche der Lichtabbildungszusammensetzung von den geätzten Metallschichten die Platinen als innerste Schicht übereinander stapelt und diese Platinen Wärme und Druck derart aussetzt, daß die Lichtabbildungszusammensetzung zunächst Hohlräume zwischen den Platinen der innersten Schicht wenigstens teilweise ausfüllt und dann härtet, um harte, dauerhafte dielektrische Schichten (22) zu bilden, die Schaltungen benachbarter innerster Schichten voneinander trennen,

**dadurch gekennzeichnet, daß** die Lichtabbildungszusammensetzung

a) 5 bis 7,1 Gew.-% Trimethylolpropantriacrylat,

b) 32,4 bis 34,3 Gew.-% eines Oligomers, welches einen Diacrylatester eines Bisphenol-A-Epoxyharzes umfaßt,

c) einen lichtempfindlichen, freie Radikale erzeugenden Initiator zur Polymerisation des Acrylatmonomers und des Oligomers,

d) 35,5 bis 37,6% eines Epoxy-Cresol-Novolac-Harzes,

e) ein Härtungsmittel für das Epoxyharz,

f) 0 bis 15 Gew.-% eines mit Hydroxylgruppen reagierenden Vernetzungsmittels, alle auf der Basis des Gesamtgewichtes der Komponenten a) bis f), und

g) bis zu 5 Gew.-% eines Füllstoffes umfaßt.

2. Verfahren nach Anspruch 1, bei dem das Trimethylolpropantriacrylat in einer Menge von wenigstens 6,7 Gew.-%, bezogen auf die Gesamtheit der Komponenten a) bis f), vorliegt.

3. Verfahren nach Anspruch 1 oder Anspruch 2, bei dem das Epoxyharz (d) ein Epoxyäquivalent von 200 bis 700 hat.

4. Verfahren nach einem der vorausgehenden Ansprüche, bei dem die Menge des lichtempfindlichen, freie Radikale erzeugenden Initiators (b) 3 bis 15% des Gesamtgewichtes der Komponenten a) bis f) beträgt.

5. Verfahren nach einem der vorausgehenden Ansprüche, bei dem die Lichtabbildungszusammensetzung 0,1 bis 10% eines sauren Härtungsmittels (e) für das Epoxyharz und 2 bis 15% des Vernetzungsmittels (f) umfaßt.

6. Verfahren nach Anspruch 5, bei dem die Lichtabbildungszusammensetzung 2 bis 5% des mit Hydroxylgruppen reaktiven Vernetzungsmittels umfaßt.

7. Verfahren nach einem der vorausgehenden Ansprüche, bei dem die Komponenten a) bis f) so ausgewählt sind, daß die Zusammensetzung in einem organischen Lösungsmittel löslich ist, um eine Lösung zu ergeben, die zu einer Zusammensetzung trocknen kann, welche in alkalischer wäßriger Lösung löslich ist, wodurch die Lichtabbildungszusammensetzung in wäßriger oder alkalisch-wäßriger Lösung entwickelbar ist.

8. Verfahren nach einem der vorausgehenden Ansprüche, bei dem das Vernetzungsmittel ein Gemisch von Cyanoguanidin und substituiertem Aminotriazin ist.

9. Verfahren nach Anspruch 8, bei dem das substituierte Triazin 2-[β-{2'-Methylimidazolyl-1'}]-ethyl-4,5-diamino-s-triazin ist.

10. Verfahren nach einem der vorausgehenden Ansprüche, bei dem der Initiator 3 bis 15 Gew.-% und das Vernetzungsmittel 1 bis 5 Gew.-% der Lichtabbildungszusammensetzung beträgt.

**11.** Fotoresistzusammensetzung mit

a) 5 bis 7,1 Gew.-% Trimethylolpropantriacrylat,

b) 32,4 bis 34,3 Gew.-% eines Oligomers, das einen Diacrylatester eines Bisphenol-A-Epoxyharzes umfaßt,

c) einem lichtempfindlichen, freie Radikale erzeugenden Initiator zur Polymerisation des Acrylatmonomers und des Oligomers,

d) 35,5 bis 37,6% eines Epoxy-Cresol-Novolac-Harzes,

e) einem Härtungsmittel für das Epoxyharz,

f) 0 bis 15 Gew.-% eines mit Hydroxylgruppen reagierenden Vernetzungsmittels, wobei alle auf der Basis des Gesamtgewichtes der Komponenten a) bis f) beruhen, und

g) bis zu 4 Gew.-% eines Füllstoffes.

**12.** Zusammensetzung nach Anspruch 11, in der das Vernetzungsmittel ein Gemisch von Cyanoguanidin und substituiertem Aminotriazin ist.

**13.** Zusammensetzung nach Anspruch 12, in der das substituierte Triazin 2-[β-{2'-Methylimidazolyl-1'}]-ethyl-4,5-diamino-s-triazin ist.

**14.** Zusammensetzung nach einem der Ansprüche 11 bis 13, worin der Initiator 3 bis 15 Gew.-% und das Vernetzungsmittel 1 bis 5 Gew.-% des Fotoresists beträgt.

**15.** Zusammensetzung nach einem der Ansprüche 11 bis 14, welche 6,7 bis 7,1 Gew.-% Trimethylolpropantriacrylat enthält.

**16.** Mehrschichtige bedruckte Schaltungsplatine (20), hergestellt mit einem permanenten als innerste Schicht dienenden Fotoresist (22), wobei dieser Fotoresist ein licht- und wärmegehärtetes Reaktionsprodukt von Komponenten a) bis f) einer Fotoresistzusammensetzung nach einem der Ansprüche 11 bis 15 und gegebenenfalls bis zu 4 Gew.-% eines Füllstoffes umfaßt.

**17.** Platine nach Anspruch 16, in der das Epoxyharz (d) ein Epoxyäquivalent von 200 bis 700 hat.

**18.** Platine nach Anspruch 16 oder Anspruch 17, in der die Menge des lichtempfindlichen, freie Radikale erzeugenden Initiators 3 bis 15% des Gesamtgewichtes der Komponenten a) bis f) beträgt.

**Revendications**

**1.** Procédé pour fabriquer une carte de circuit imprimé multicouche (20) comprenant :

(A) la constitution d'une pluralité de cartes de couche interne (10) dont chacune comprend une base diélectrique (12) et comporte au moins une couche métallique (14) dessus ;
(B) le revêtement de chacune desdites couches métalliques avec une couche en une composition photo-imageable (16), laquelle composition photo-imageable peut être durcie afin de former un matériau diélectrique permanent dur et comprend (a) un monomère acrylate polymérisable, (b) un oligomère qui est constitué d'un diester d'une résine époxy bisphénol A et d'un acide acrylique ou méthacrylique, (c) un initiateur de génération de radicaux libres photosensible pour la polymérisation du monomère acrylique et de l'oligomère, (d) une résine époxy durcissable, (e) un agent de durcissement pour la résine époxy et optionnellement (f) de 0% à 15% en poids d'un agent de réticulation qui réagit avec des groupes hydroxyle, le tout étant basé sur le poids total des composants (a) à (f);
(C) l'exposition de chacune desdites couches de matériau photo-imageable à un rayonnement actinique conformé ;
(D) le développement desdites couches exposées afin d'enlever soit des parties exposées, soit des parties non exposées en laissant des parties non exposées ou exposées desdites couches de composition photo-imageable (16) sur lesdites couches métalliques (14) ;

(E) la gravure desdites couches métalliques desdites cartes de couche interne afin d'enlever des parties desdites couches métalliques desquelles lesdites parties desdites couches de composition photo-imageable ont été enlevées ; et

(F) sans enlever des parties restantes de ladite composition photo-imageable desdites couches métalliques gravées, l'empilement desdites cartes de couche interne et la soumission desdites cartes à une chaleur et une pression de telle sorte que ladite composition photo-imageable remplisse initialement des vides entre les cartes de couche interne au moins partiellement puis durcisse pour former des couches diélectriques permanentes dures (22) séparant un circuit de couches internes adjacentes,

**caractérisé en ce que** la composition photo-imageable comprend :

(a) de 5% à 7,1% en poids de triacrylate de triméthylolpropane ;
(b) de 32,4% à 34,3% en poids d'un oligomère comprenant un ester diacrylate d'une résine époxy bisphénol A ;
(c) un initiateur de génération de radicaux libres photosensible pour la polymérisation du monomère acrylate et de l'oligomère ;
(d) de 35,5% à 37,6% en poids d'une résine novolac crésol époxy ;
(e) un agent de durcissement pour la résine époxy ;
(f) de 0% à 15% en poids d'un agent de réticulation qui réagit avec des groupes hydroxyle, le tout étant basé sur le poids total des composants (a) à (f) ; et
(g) jusqu'à 4% en poids d'un agent de remplissage.

2. Procédé selon la revendication 1, dans lequel le triacrylate de triméthylolpropane est présent selon une quantité d'au moins 6,7% en poids sur la base du total des composants (a) à (f).

3. Procédé selon la revendication 1 ou 2, dans lequel la résine époxy (d) comporte un équivalent époxyde de 200 à 700.

4. Procédé selon l'une quelconque des revendications précédentes, dans lequel la quantité de l'initiateur de génération de radicaux libres photosensible (b) est comprise entre 3% et 15% du poids total des composants (a) à (f).

5. Procédé selon l'une quelconque des revendications précédentes, dans lequel la composition photo-imageable comprend de 0,1% à 10% d'un agent de durcissement acide (e) pour la résine époxy et de 2% à 15% de l'agent de réticulation (f).

6. Procédé selon la revendication 5, dans lequel la composition photo-imageable comprend de 2% à 5% de l'agent de réticulation réagissant au groupe hydroxyle.

7. Procédé selon l'une quelconque des revendications précédentes, dans lequel lesdits composants (a) à (f) sont choisis de telle sorte que la composition soit soluble dans un solvant organique afin d'obtenir une solution pouvant sécher selon une composition qui est soluble dans une solution aqueuse alcaline et ainsi, ladite composition photo-imageable peut être développée dans une solution aqueuse ou une solution aqueuse alcaline.

8. Procédé selon l'une quelconque des revendications précédentes, dans lequel l'agent de réticulation est un mélange de cyanoguanidine et de triazine amino substituée.

9. Procédé selon la revendication 8, dans lequel la triazine substituée est 2-[β-{2'-méthylimidazolyl-1'}]-éthyl-4,5-diamino-s-triazine.

10. Procédé selon l'une quelconque des revendications précédentes, dans lequel l'initiateur est compris entre 3% et 15% et l'agent de réticulation est compris entre 1% et 5% en poids de la composition photo-imageable.

11. Composition de photoréserve comprenant :

(a) de 5% à 7,1% en poids de triacrylate de triméthylolpropane ;
(b) de 32,4% à 34,3% en poids d'un oligomère comprenant un ester diacrylate d'une résine époxy bisphénol A ;
(c) un initiateur de génération de radicaux libres photosensible pour la polymérisation du monomère acrylate et de l'oligomère ;

(d) de 35,5% à 37,6% en poids d'une résine novolac crésol époxy ;

(e) un agent de durcissement pour la résine époxy ;

(f) de 0% à 15% en poids d'un agent de réticulation qui réagit avec des groupes hydroxyle, le tout étant basé sur le poids total des composants (a) à (f); et

(g) jusqu'à 4% en poids d'un agent de remplissage.

12. Composition selon la revendication 11, dans laquelle l'agent de réticulation est un mélange de cyanoguanidine et de triazine amino substituée.

13. Composition selon la revendication 12, dans laquelle la triazine substituée est 2-[β-{2'-méthylimidazolyl-1'}]-éthyl-4,5-diamino-s-triazine.

14. Composition selon l'une quelconque des revendications 11 à 13, dans laquelle l'initiateur est compris entre 3% et 15% et l'agent de réticulation est compris entre 1% et 5% en poids de la photoréserve.

15. Composition selon l'une quelconque des revendications 11 à 14, laquelle contient de 6,7% à 7,1% en poids de triacrylate de triméthylolpropane.

16. Carte de circuit imprimé multicouche (20) fabriquée avec une photoréserve de couche interne permanente (22), ladite photoréserve comprenant un produit de réaction durci à la lumière et à la chaleur formé par des composants (a) à (f) d'une composition de photoréserve selon l'une quelconque des revendications 11 à 15 et optionnellement par jusqu'à 4% en poids d'un agent de remplissage.

17. Carte selon la revendication 16, dans laquelle la résine époxy (d) comporte un équivalent époxyde de 200 à 700.

18. Carte selon la revendication 16 ou 17, dans laquelle la quantité de l'initiateur de génération de radicaux libres photosensible est comprise entre 3% et 15% du poids total des composants (a) à (f).

FIG. I

FIG.2